# FASCICULE DE BREVET EUROPEEN

(11) **EP 2 280 414 B1**
(45) Date de publication et mention de la délivrance du brevet: **03.09.2014**
(21) Numéro de dépôt: 10170396.5
(22) Date de dépôt: 22.07.2010
(51) Int. Cl.: H01L 27/092, H02H 11/00, H01L 27/02, H02H 9/04, H01L 27/088

(54) **Dispositif électronique de protection contre une inversion de polarité d'une tension d'alimentation continue, et application au domaine de l'automobile**
Elektronische Vorrichtung zum Schutz gegen Sperrspannung und ihre Anwendung im Automobilbereich
Electronic device for reverse bias protection, and application in automotive field

(30) Priorité: 28.07.2009 FR 0955273
(43) Date de publication de la demande: 02.02.2011
(73) Titulaire: STMicroelectronics (Rousset) SAS, 13790 Rousset (FR)
(72) Inventeur: Pavlin, Antoine, 13540, PUYRICARD (FR)
(74) Mandataire: Zapalowicz, Francis

(56) Documents cités:
- EP-A2- 0 626 745
- EP-A2- 1 840 965
- US-A- 5 517 379
- US-A- 5 682 050
- US-B1- 6 426 857
- HAO-PING HONG ET AL: "A reverse-voltage protection circuit for MOSFET power switches" IEEE JOURNAL OF SOLID-STATE CIRCUITS IEEE USA, vol. 36, no. 1, janvier 2001 (2001-01), pages 152-155, XP002569173 ISSN: 0018-9200

## Description

L'invention concerne la protection de composants électroniques contre une inversion de polarité d'une tension d'alimentation, et plus particulièrement les circuits intégrés permettant la réalisation d'une telle protection.

L'invention s'applique avantageusement mais non limitativement au domaine de l'automobile pour la protection d'une entité électronique telle que par exemple une unité de contrôle ou un processeur, contre une inversion de la polarité attendue de la tension d'alimentation continue destinée à cette entité électronique.

Les dispositifs de protection contre des inversions de polarité d'une tension d'alimentation continue permettent d'éviter la circulation de courants inverses à travers des composants électroniques lors de ladite inversion de polarité.

Actuellement, plusieurs solutions existent pour réaliser une protection contre ces inversions de polarité.

On peut citer notamment la mise en série de diodes dans la ligne d'alimentation. Cependant, une telle solution génère des dissipations de puissance inacceptables, dès lors que le courant dans l'entité électronique à protéger, par exemple une unité de contrôle, dépasse 5 ampères. Or, des unités de contrôle électroniques utilisables dans des applications automobiles peuvent contrôler des courants de charge allant de 20 à 40 ampères. En outre, les diodes en série en combinaison avec l'inductance de la ligne d'alimentation, et les condensateurs des filtres d'alimentation habituellement présents dans les unités de contrôle électronique, créent un circuit résonnant redressé qui peut générer des conditions de surtension sur la ligne d'alimentation de l'unité électronique de contrôle à protéger.

Une autre solution consiste à insérer un relais électromécanique dans la ligne d'alimentation positive, la bobine de commande étant alimentée entre les bornes d'alimentation positive et négative. Un tel montage force le relais à se fermer en présence d'une différence de tension minimum entre les bornes positive et négative de l'alimentation et force le relais à s'ouvrir si la tension présente à la borne d'alimentation positive chute à une valeur proche de zéro ou devient négative par rapport à la borne négative d'alimentation.

Une telle solution ne présente pas les inconvénients de la solution précédente mais requiert des relais volumineux, ce qui peut être incompatible avec l'emplacement physique destiné à recevoir l'entité électronique à protéger. En outre, de tels relais doivent être assemblés manuellement sur l'entité électronique lorsque le courant véhiculé par cette dernière excède quelques ampères, car de tels relais ne peuvent pas être montés en tant que composants de surface.

Une autre solution consiste à placer un transistor MOS à canal P dans la ligne d'alimentation positive. Bien que cette solution offre l'avantage de la simplicité d'un circuit de commande du transistor PMOS, elle présente néanmoins un inconvénient au niveau de l'encombrement surfacique en raison de la taille importante d'un transistor PMOS de puissance.

Une autre solution consiste à placer un transistor MOS à canal N dans la ligne de polarité négative. Cependant, une telle solution requiert que la borne négative de sortie de l'unité électronique à protéger, à laquelle sont connectées des charges, soit connectée en retour à la borne d'alimentation négative de cette unité électronique de façon à éviter la circulation de courants négatifs dans toutes les charges connectées à l'unité électronique lors d'une inversion de polarité de la tension d'alimentation. Or, dans certaines applications, par exemple des applications automobiles, les bornes négatives des charges sont directement connectées en retour à la borne d'alimentation négative sans repasser par l'unité électronique qui contrôle ces charges.

En outre, des composants analogiques externes à l'unité électronique, par exemple des capteurs, peuvent ne pas être électriquement compatibles avec des bornes d'entrée d'unité électronique devenant négatives lors d'une inversion de polarité.

Il a encore été proposé dans l'art antérieur d'insérer un transistor à canal N dans la ligne d'alimentation positive associé à un composant de commande discret externe, tel qu'une pompe de charge, capable de fournir une tension de commande sur la grille du transistor supérieure à la tension d'alimentation en fonctionnement normal. Un example de ce type de protection est proposé dans le document US 5517379-A. Cependant, une telle solution utilisant une pompe de charge discrète externe présente un encombrement surfacique important, et conduit à générer un fort bruit électromagnétique en raison de la valeur relativement élevée des condensateurs de la pompe de charge utilisés dans les réalisations discrètes de pompes de charge.

Selon un mode de réalisation, il est proposé un dispositif de protection contre une inversion de polarité d'une tension d'alimentation continue qui soit compatible avec un assemblage du type à composants de montage en surface, présentant une émission électromagnétique réduite avec un encombrement surfacique réduit.

Selon un mode particulièrement avantageux de réalisation, il est proposé un dispositif électronique de protection contre une inversion de polarité d'une tension d'alimentation continue comprenant, réalisés au sein d'un même circuit intégré, un transistor principal à canal N, par exemple un transistor NMOS de puissance, monté sur la ligne de polarité positive attendue de la tension d'alimentation, ainsi que des moyens de commande du transistor principal comportant un circuit de pompe de charge, associés à un circuit de polarisation dynamique des régions de substrat de composants, notamment des composants actifs, tels que, par exemple des transistors ou des diodes, connectés au transistor principal.

Plus généralement, selon un aspect, il est proposé un dispositif électronique, comprenant des moyens d'entrée possédant une première borne d'entrée destinée à recevoir une polarité positive attendue d'une tension d'alimentation continue d'entrée, des moyens de sortie possédant une première borne de sortie destinée à délivrer la polarité positive d'une tension d'alimentation continue de sortie, et des moyens électroniques de protection contre une inversion de polarité de la tension d'alimentation d'entrée, couplés entre les moyens d'entrée et les moyens de sortie.

Selon une caractéristique générale de cet aspect, les moyens de protection sont réalisés de façon intégrée et comprennent
- un transistor principal à canal N dont la source est couplée à la première borne d'entrée et dont le drain est couplé à la première borne de sortie,
- des moyens de commande configurés pour rendre le transistor principal bloqué en cas d'inversion de polarité et passant dans le cas contraire, et
- des moyens de contrôle configurés pour ajuster dynamiquement la polarisation des régions de substrat de composants, notamment actifs, connectés au transistor principal.

Le fait de réaliser de façon intégrée les moyens de protection, et en particulier les moyens de commande, par exemple un circuit de pompe de charge, et le transistor principal, que ce soit au sein d'un même circuit intégré (au sein d'une même puce) ou au sein de deux circuits intégrés différents mutuellement connectés (un circuit intégré pour le transistor principal, par exemple un transistor de puissance, et un autre circuit intégré pour le reste des moyens de protection) permet l'utilisation d'un circuit de pompe de charge multiphases optimisé utilisant des condensateurs de petite taille commutés à haute fréquence, avec une connexion extrêmement courte entre les moyens de commande et la grille du transistor principal, et une émission électromagnétique extrêmement réduite.

En outre, le transistor principal est utilisé en diode de protection ; il est traversé par un courant allant de la source vers le drain soit un sens du courant inversé par rapport à l'utilisation standard.

Par ailleurs, une telle réalisation intégrée nécessite de prévoir un ajustement dynamique de la polarisation des régions de substrat de composants, notamment actifs, connectés au transistor principal, de façon à assurer un fonctionnement correct du dispositif électronique. Plus précisément ces composants, actifs ou passifs, sont généralement ceux dont les régions de substrat (les caissons par exemple) sont électriquement connectées à la source ou au drain du transistor principal, ou en d'autres termes ceux dont les régions de substrat (les caissons par exemple) sont susceptibles de passer en polarisation directe par rapport à la région semiconductrice sous-jacente à cette région de substrat et de conductivité opposée (le substrat général de la plaquette semiconductrice de conductivité opposée ou bien un autre caisson de conductivité opposée).

A l'inverse d'une polarisation qui serait fixe ou figée, une polarisation dynamique des régions de substrat signifie que ces régions peuvent être polarisées avec des tensions différentes selon l'état des moyens de protection, et en particulier des valeurs relatives de la tension d'alimentation d'entrée et de la tension d'alimentation de sortie.

Plus précisément, et selon un mode de réalisation dans lequel les régions de substrat, communément désignées sous la dénomination anglosaxonne de « bulk » par l'homme du métier, et qui peuvent être des caissons semiconducteurs, sont réalisées au sein de régions semiconductrices ayant une conductivité opposée à celle des régions de substrat, par exemple la zone de substrat général de la plaquette ou bien un autre caisson lui-même réalisé dans la zone de substrat général de la plaquette, ces régions semiconductrices sont connectées soit à la première borne de sortie soit à la masse, en fonction du type de conductivité de ces régions semiconductrices ; par ailleurs, les moyens de contrôle sont configurés pour connecter les régions de substrat soit à la source soit au drain du transistor principal en fonction de la valeur des tensions présentes à ces deux électrodes (source et drain) et du type de conductivité de ces régions de substrat.

Ainsi, par exemple lorsque les régions de substrat (telles que des caissons) des composants, notamment actifs, précités sont de type de conductivité P ménagées dans des régions semiconductrices de type de conductivité N (par exemple le substrat N de la plaquette dans une technologie N ou bien un caisson N au sein d'un substrat de plaquette de type P dans une technologie P), ces régions semiconductrices de type N sont connectées à la première borne de sortie, et les moyens de contrôle sont configurés pour relier lesdites régions de substrat P (caissons P) à la source du transistor principal si la tension de source est inférieure à la tension de drain, ou au drain du transistor principal si la tension de source est supérieure à la tension de drain.

Bien entendu, de façon duale, si les régions de substrat des composants, notamment actifs, de type de conductivité N sont ménagées dans des régions semiconductrices de type de conductivité P, ces régions semiconductrices seront connectées à la masse, et les moyens de contrôle sont alors configurés pour relier les régions de substrat N à la source du transistor principal si la tension de source est supérieure à la tension de drain ou au drain du transistor principal si la tension de source est inférieure à la tension de drain.

Cela étant, selon un mode de réalisation, les moyens de contrôle comportent un comparateur dont les deux entrées sont respectivement connectées à la source et au drain du transistor principal, et un multiplexeur possédant une entrée connectée auxdites régions de substrat, deux sorties respectivement connectées à la source et au drain du transistor principal, et une entrée de commande connectée à la sortie du comparateur.

Selon un mode particulièrement avantageux de réalisation, les moyens de contrôle comportent :
- un premier transistor de contrôle ayant une région de substrat connectée à sa source, un drain connecté à la source du transistor principal, et une grille connectée au drain du transistor principal, et
- un deuxième transistor de contrôle, configuré pour être toujours passant, ayant sa source connectée au drain du transistor principal, sa région de substrat connectée à son drain ainsi qu'à la région de substrat du premier transistor de contrôle et sa grille connectée à son drain, le drain de ce deuxième transistor de contrôle étant par ailleurs connecté à la source du premier transistor de contrôle, et
- les régions de substrat de certains desdits composants, notamment actifs, sont connectées aux régions de substrat des premier et deuxième transistors de contrôle qui font eux-mêmes partie desdits composants, notamment actifs.

Comme indiqué ci-avant, les moyens de commande peuvent comprendre un circuit de pompe de charge dont la sortie est connectée à la grille du transistor principal, avec, de préférence, un circuit de régulation de tension connecté à la première borne de sortie et alimentant la pompe de charge.

Le dispositif est avantageusement réalisé en technologie de type N au sein d'un même circuit intégré et le transistor principal peut être un transistor de MOS de puissance, en particulier pour une application du dispositif tel que défini ci-avant, à la protection d'une unité électronique d'un véhicule automobile contre des inversions de polarité d'alimentation continue.

Selon un autre aspect, il est également proposé un système comprenant un générateur d'une tension d'alimentation continue, par exemple une batterie d'un véhicule automobile, une unité électronique destinée à être alimentée par une tension continue et un dispositif tel que défini ci-avant couplé entre le générateur et l'unité électronique.

D'autres avantages et caractéristiques de l'invention apparaîtront à l'examen de la description détaillée de modes de réalisation, nullement limitatifs, et des dessins annexés, sur lesquels :
- la figure 1 illustre schématiquement un mode de réalisation d'un dispositif selon l'invention ;
- la figure 2 illustre schématiquement un exemple de réalisation intégré de composants du dispositif de la figure 1 ; et
- la figure 3 illustre schématiquement mais plus en détails une partie du dispositif de la figure 1.

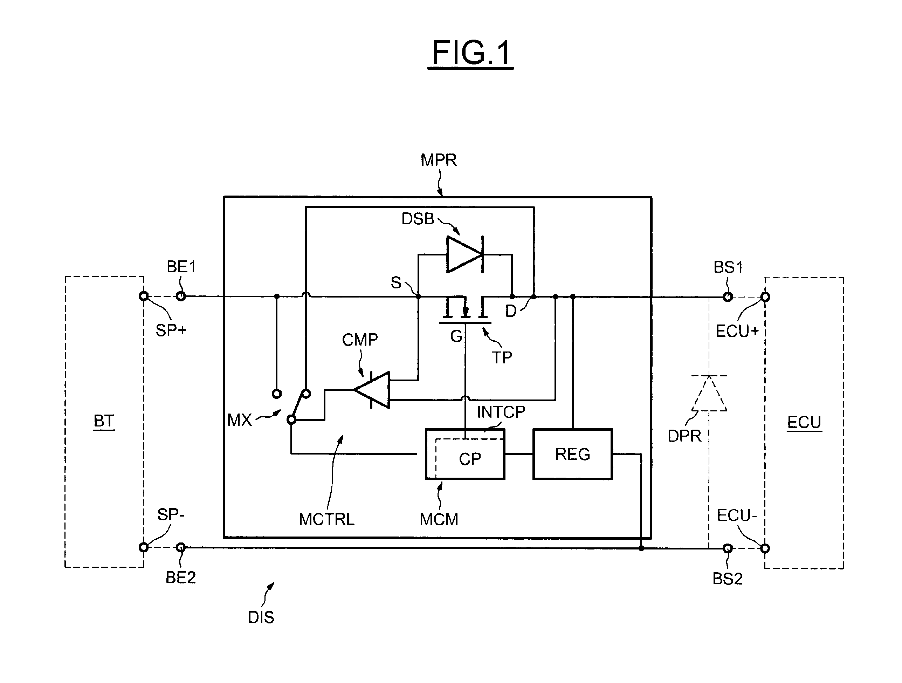

Sur la figure 1, la référence DIS désigne un dispositif électronique de protection contre une inversion de polarité d'une tension d'alimentation continue.

Plus précisément, ce dispositif DIS comporte des moyens d'entrée possédant une première borne d'entrée BE1 destinée à recevoir une polarité positive attendue d'une tension d'alimentation continue d'entrée, et une deuxième borne d'entrée BE2 destinée à recevoir la polarité négative de la tension d'alimentation, cette dernière étant généralement la masse.

La première borne d'entrée BE1 est couplée à la borne positive SP+ d'un générateur BT, tel qu'une batterie de véhicule, délivrant la polarité positive attendue de la tension d'alimentation continue d'entrée.

La deuxième borne d'entrée BE2 est reliée à la borne négative SP- du générateur BT.

Le dispositif DIS comporte également des moyens de sortie comprenant une première borne de sortie BS1 destinée à délivrer la polarité positive d'une tension d'alimentation continue de sortie, et une deuxième borne de sortir BS2 destinée à délivrer la polarité négative de la tension d'alimentation continue de sortie, en général la masse.

Ces deux bornes de sortie sont respectivement connectées aux deux bornes d'entrée + et -, respectivement référencées ECU+ et ECU-d'une entité électronique, par exemple une unité de commande électronique ECU d'un véhicule automobile.

La ligne reliant les bornes BE1 et BS1 est la ligne de polarité positive attendue de la tension d'alimentation, et on voit sur la figure 1 qu'un transistor principal MOS à canal N, référencé TP, est monté sur cette ligne de polarité positive.

Le transistor principal TP fait partie de moyens électroniques MPR de protection contre une inversion de polarité de la tension d'alimentation d'entrée.

Ces moyens MPR sont couplés entre les moyens d'entrée BE1, BE2 et les moyens de sortie BS1, BS2.

La source S du transistor principal TP est connectée à la première borne d'entrée BE1 tandis que le drain D de ce transistor TP est connecté à la première borne de sortie BS1.

Outre le transistor principal TP, les moyens de protection MPR comportent des moyens de commande MCM configurés pour rendre le transistor principal bloqué en cas d'inversion de polarité et passant dans le cas contraire, et des moyens de contrôle MCTRL configurés pour ajuster dynamiquement la polarisation des régions de substrat de composants actifs connectés au transistor principal.

Les moyens de commande MCM comportent ici un circuit de pompe de charge CP capable de délivrer sur la grille G du transistor principal TP une tension supérieure à la tension délivrée à la borne d'entrée BE1 en mode de fonctionnement normal. Typiquement, si la tension délivrée en fonctionnement normal sur la borne BE1 est de l'ordre de 13 volts, la pompe de charge CP est capable de délivrer par exemple une tension de l'ordre de 22 volts.

Comme il est bien connu de l'homme du métier, un circuit de pompe de charge comprend un oscillateur et des étages capacitifs de charge successifs pour fournir une tension de sortie supérieure à la tension d'alimentation. Ces étages capacitifs peuvent être réalisés avec des capacités commutées.

Comme on le verra plus en détails ci-après, un circuit d'interface INTCP est connecté entre la sortie de la pompe de charge proprement dite, c'est-à-dire de la sortie des étages capacitifs, et le transistor principal TP.

La pompe de charge est alimentée à partir de la borne de sortie BS1. Ceci permet de protéger le circuit de pompe de charge des tensions négatives puisque, comme indiqué ci-avant et comme explicité plus en détails ci-après, le transistor principal TP sera bloqué lorsque la tension délivrée sur la borne BE1 devient négative.

Il serait possible d'alimenter directement le circuit de pompe de charge CP entre les bornes BS1 et BS2, mais dans ce cas il conviendrait de prévoir un circuit de limitation de tension, comme par exemple une diode DPR dont la cathode serait connectée à la borne BS1, de façon à limiter la tension d'alimentation du circuit de pompe de charge en deçà de sa limite de tension acceptable.

On pourra par exemple utiliser une diode DPR de type Zener 10 volts.

Une autre solution, préférable, est celle illustrée sur la figure 1, qui prévoit d'intégrer un régulateur de tension REG connecté entre la borne BS1 et la masse, (éventuellement via un interrupteur), capable de supporter la différence de tension maximale et destiné à alimenter le circuit de pompe de charge.

Les moyens de protection MPR du dispositif DIS sont réalisés de façon intégrée.

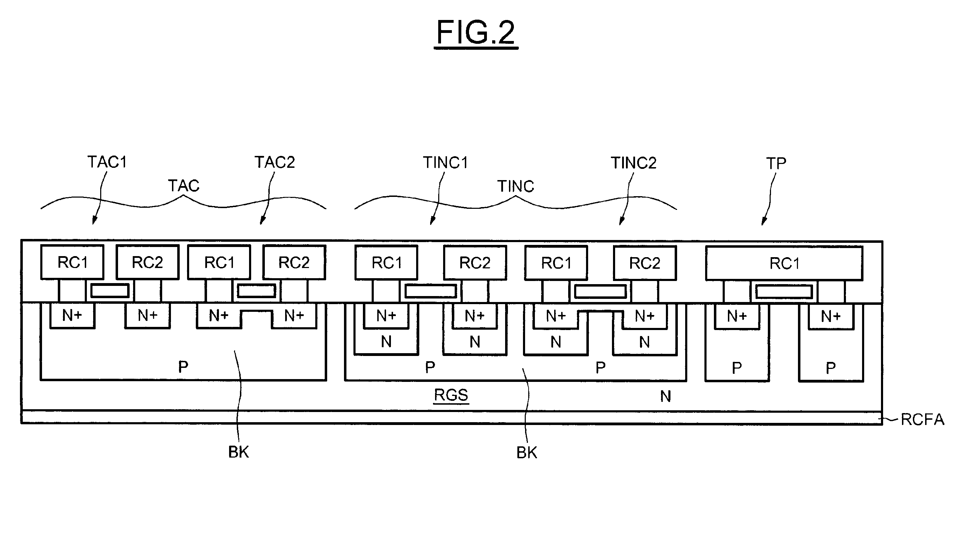

La figure 2 illustre un exemple de composants actifs, tels que des transistors, utilisés dans les moyens de protection MPR et réalisés ici en technologie N.

Plus précisément, dans une technologie N, les transistors à canal N, tels que les transistors TAC ou TINC, sont réalisés au sein de caissons BK de type de conductivité P et formant pour ces transistors des régions de substrat de type P.

Ces caissons P sont par conséquent ménagés au sein d'une région semiconductrice RGS de type de conductivité N qui est en fait ici dans cet exemple le substrat N de la plaquette (Wafer) semiconductrice.

Les transistors TINC sont, dans cet exemple et dans la technologie utilisée, des transistors capables de supporter une tension de 20 volts, et utilisables par exemple dans l'interface INTCP.

Les contacts RC1, RC2 de ces transistors sont les contacts de source/drain.

A titre indicatif, le transistor TINC1 est un transistor à canal N à enrichissement, tandis que le transistor TINC2 est un transistor à canal N à appauvrissement.

Les transistors TAC 1 et TAC2 dont les zones de contact RC1 et RC2 désignent également les contacts source/drain, sont également, en ce qui concerne le transistor TAC1, un transistor à canal N à enrichissement, et en ce qui concerne le transistor TAC2, un transistor à canal N à appauvrissement. Ces transistors TAC sont par contre utilisés dans les circuits analogiques à plus faible tension, par exemple 10 volts.

Dans cet exemple, la région semiconductrice RGS de type N est connectée en permanence à la première borne de sortie BS1, c'est-à-dire au drain du transistor principal TP.

Par contre, la polarisation des régions de substrat ou caissons de type P de certains composants actifs connectés au transistor principal va être ajustée dynamiquement par les moyens de contrôle MCTRL en fonction des valeurs de tension à la source et au drain du transistor TP. Plus précisément, si la tension de source du transistor TP est inférieure à la tension de drain, alors les régions de substrat BK de type P des composants actifs TINC par exemple, sont connectées à la source S du transistor principal.

Par contre, si la tension de source du transistor principal est supérieure à la tension de drain, alors ces caissons BK sont reliés au drain du transistor TP.

On a également illustré, sur la partie droite de la figure 2, un exemple de réalisation du transistor TP qui est ici un transistor à canal N de puissance, vertical. La zone de contact RC1 est la zone de contact de source tandis que la zone de contact en face arrière de la région RGS, référencée RCFA, est la zone de contact de drain de ce transistor TP.

On voit donc sur cette figure 2, que l'utilisation d'une technologie de type N permet de réaliser aisément, au sein du même circuit intégré, l'ensemble des moyens de protection MPR.

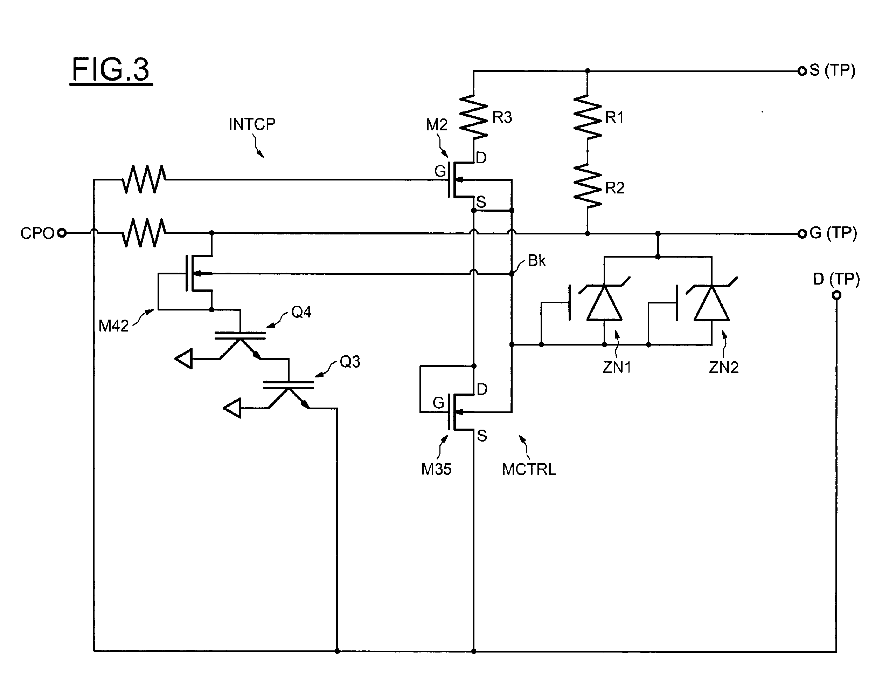

Avant de décrire la figure 3 qui illustre plus en détails un exemple de réalisation de l'interface INTCP et des moyens de contrôle MCTRL, on va décrire le fonctionnement du dispositif DIS.

On suppose dans un premier temps que l'on met en route l'alimentation d'entrée. En d'autres termes, la tension délivrée à la borne d'entrée BE1 passe de « 0 » à une tension nominale positive, par exemple 13 volts.

Le transistor principal TP étant monté de façon à ce que sa diode source/drain DSB soit passante lorsque la tension de source est supérieure à la tension de drain, la tension délivrée à la borne de sortie BS1 suit la tension d'entrée à un seuil de diode près, tout en restant inférieure à cette tension d'entrée. En d'autres termes, la tension de drain est inférieure à la tension de source. Par conséquent, les caissons P des composants actifs mentionnés ci-avant sont reliés au drain du transistor TP par l'intermédiaire du multiplexeur MX commandé par le comparateur CMP.

En effet, dans la technologie utilisée dans cet exemple, les caissons P ne peuvent pas être polarisés à une tension supérieure à celle de la région semiconductrice RGS de type N.

Lorsque la tension à la borne de sortie BS1 est suffisante pour faire fonctionner le régulateur de tension REG, celui-ci alimente la pompe de charge CP qui délivre alors une tension sur la grille G du transistor TP bien supérieure à la tension de source, par exemple une tension de l'ordre de 22 volts, rendant par conséquent ce transistor TP passant. La tension délivrée à la borne BS1 est alors sensiblement identique à la tension reçue à la borne BE1.

Lorsque l'on inverse la polarité de la tension d'alimentation d'entrée, la tension de source du transistor TP devient inférieure à sa tension de drain. Dans ce cas, les caissons P des composants actifs mentionnés ci-avant sont reliés à la source du transistor TP au moyen du multiplexeur MX commandé par le comparateur CMP.

L'inversion de polarité en entrée provoque la chute de la tension à la borne BE1 qui entraîne par conséquent la chute de la tension au niveau de la borne BS1. Cette chute de tension va provoquer l'arrêt du circuit de régulation REG et donc l'arrêt de l'alimentation de la pompe de charge CP.

Celle-ci ne délivre alors plus de courant et la grille G du transistor principal TP va se décharger pour suivre le potentiel de la source S de ce transistor TP. Il en résulte donc un blocage du transistor TP et la tension à la borne de sortie BS1 va se stabiliser au voisinage de 0 volt.

On se réfère maintenant à la figure 3, qui illustre un exemple de réalisation de l'interface INTCP et des moyens de contrôle MCTRL.

Sur la figure 3, la référence CPO désigne la sortie des étages capacitifs du circuit de pompe de charge et on voit que cette borne CPO est reliée à la grille G du transistor principal TP.

Par ailleurs, l'interface INTCP comporte ici un transistor M42 connecté entre la grille G du transistor TP et son drain D par l'intermédiaire d'un groupe de transistors bipolaires Q3 et Q4.

Les transistors Q3, Q4 et M42 permettent la remise en conduction du transistor TP lorsque la tension négative sur sa source atteint une valeur fixée. Ceci permet d'assurer que le transistor TP reste bloqué en cas d'inversion statique de polarité de l'alimentation, tout en protégeant le dispositif contre les impulsions de tension négatives auxquelles le module électronique (ECU) doit survivre lors des tests de qualification normalement exigés dans les applications automobiles. Par exemple la norme ISO 7637/2 spécifie que le module doit supporter une impulsion de -100V/10Ohms/2ms. Dans ce cas, le composant décrit ici se remettra en conduction lorsque la tension source du transistor TP atteindra environ -20V, et une impulsion de courant de (100V-20V)/10Ohms=8A circulera entre ECU- et ECU+ à travers les diodes normalement présentes entre ces deux bornes.

L'interface INTCP comporte également un chemin résistif R1, R2 connecté entre la grille G et la source du transistor principal TP, et qui va permettre la décharge de la grille du transistor TP pour suivre le potentiel de source lors de l'inversion de polarité, comme expliqué ci-avant.

L'interface INTCP comporte également des diodes Zener de protection ZN1 et ZN2, connectées entre la grille et le drain du transistor TP.

Les composants actifs de l'interface INTCP que l'on a évoqués précédemment en ce qui concerne la polarisation dynamique de leur caisson P sont ici le transistor M42 et les diodes de protection ZN1 et ZN2.

Les moyens de contrôle MCTRL sont réalisés dans cet exemple par un inverseur, formés d'un premier transistor de contrôle M2 et d'un deuxième transistor de contrôle M35.

Plus précisément, le premier transistor de contrôle M2, à canal N, a une région de substrat BK connectée à sa source S et son drain D est connecté à la source S du transistor TP par l'intermédiaire d'une résistance R3.

La grille G de ce premier transistor de contrôle M2 est par ailleurs reliée au drain D du transistor principal TP.

Le deuxième transistor de contrôle M35 est un transistor à canal N à appauvrissement configuré pour être toujours passant et moins conducteur que le transistor M2 dans son état passant.

Plus précisément, la source de ce transistor de contrôle M35 est reliée au drain du transistor principal TP. Sa grille G est reliée à son drain D et sa région de substrat BK ou caisson, est reliée à la source du transistor M2 et par conséquent, au drain du transistor M35 puisque la source S du transistor M2 et le drain D du transistor M35 sont reliés.

Ces deux transistors M2 et M35 font également partie des composants actifs dont les caissons BK de type P doivent être polarisés dynamiquement.

Par ailleurs, on remarque bien évidemment sur la figure 3, que toutes les régions de substrat BK de ces composants actifs M42, M2, M35, ZN1 et ZN2 sont reliés ensemble.

Les deux transistors de contrôle M2 et M35 font office, comme indiqué précédemment, à la fois de comparateur CMP et de multiplexeur MX.

En effet, si la tension de source du transistor principal est supérieure à la tension de drain du transistor principal, le transistor M2 est bloqué car le potentiel de sa grille est inférieur au potentiel de sa source. En conséquence, les régions de substrat ou caisson BK des composants actifs sont connectées au drain du transistor principal TP puisque le transistor M35 est toujours passant.

Si par contre la tension de source du transistor principal TP devient inférieure à la tension de drain du transistor TP, le transistor M2 conduit, car sa tension de grille devient supérieure à sa tension de source mais, comme le transistor M35 est conçu pour conduire moins de courant que le transistor M2, les régions de substrat BK des composants actifs sont, cette fois-ci, connectées à la source du transistor TP.

## Revendications

1. Dispositif électronique, comprenant des moyens d'entrée possédant une première borne d'entrée (BE1) destinée à recevoir une polarité positive attendue d'une tension d'alimentation continue d'entrée, des moyens de sortie possédant une première borne de sortie (BS1) destinée à délivrer la polarité positive d'une tension d'alimentation continue de sortie, et des moyens électroniques de protection (MPR) contre une inversion de polarité de la tension d'alimentation d'entrée, couplés entre les moyens d'entrée et les moyens de sortie, **caractérisé en ce que** les moyens de protection (MPR) sont réalisés de façon intégrée et comprennent un transistor principal à canal N (TP) dont la source (S) est couplée à la première borne d'entrée (BE1)et dont le drain (D) est couplé à la première borne de sortie (BS1), des moyens de commande (MCM) configurés pour rendre le transistor principal (TP) bloqué en cas d'inversion de polarité et passant dans le cas contraire, et des moyens de contrôle (MCTRL) configurés pour ajuster dynamiquement la polarisation des régions de substrat (BK) de composants (M42, M2, M35) connectés au transistor principal (TP), et
les régions de substrat (BK) desdits composants sont réalisées au sein de régions semi-conductrices (RGS) ayant une conductivité opposée à celle des régions de substrat, les régions semi-conductrices (RGS) étant connectées soit à la première borne de sortie (BS1) soit à la masse en fonction du type de conductivité de ces régions semi-conductrices, et les moyens de contrôle (MCTRL) sont configurés pour connecter les régions de substrat (BK) soit la source soit au drain du transistor principal en fonction de la valeur des tensions présentes à ces deux électrodes et du type de conductivité de ces régions de substrat.

2. Dispositif selon la revendication 1, dans lequel les régions de substrat (BK) desdits composants sont de type de conductivité P ménagées dans des régions semi-conductrices RGS) de type de conductivité N connectées à la première borne de sortie, et les moyens de contrôle (MCTRL) sont configurés pour relier lesdites régions de substrat P à la source du transistor principal si la tension de source est inférieure à la tension de drain ou au drain du transistor principal si la tension de source est supérieure à la tension de drain.

3. Dispositif selon la revendication 1 ou 2, dans lequel les moyens de contrôle (MCTRL) comportent un comparateur (CMP) dont les deux entrées sont respectivement connectées à la source et au drain du transistor principal (TP), et un multiplexeur (MX) possédant une entrée connectée auxdites régions de substrat, deux sorties respectivement connectées à la source et au drain du transistor principal et une entrée de commande connectée à la sortie du comparateur.

4. Dispositif selon la revendication 1, 2 ou 3, dans lequel les moyens de contrôle (MCTRL) comportent un premier transistor de contrôle (M2) ayant une région de substrat connectée à sa source, dont le drain est connecté à la source du transistor principal et dont la grille est connectée au drain du transistor principal, et un deuxième transistor de contrôle (M35), configuré pour être toujours passant, ayant sa source connectée au drain du transistor principal, sa région de substrat connectée à son drain ainsi qu'à la région de substrat du premier transistor de contrôle et sa grille connectée à son drain, le drain de ce deuxième transistor de contrôle étant connecté à la source du premier transistor de contrôle, les régions de substrat (BK) desdits composants (M42, ZN1, ZN2) étant connectés aux régions de substrat des premier et deuxième transistors de contrôle (M2, M35) qui font eux-mêmes partie desdits composants.

5. Dispositif selon l'une des revendications précédentes, dans lequel les moyens de commande (MCM) comprennent un circuit de pompe de charge (CP) dont la sortie est connectée à la grille du transistor principal.

6. Dispositif selon la revendication 5, dans lequel les moyens de commande (MCM) comprennent un circuit de régulation de tension (RG) connecté à la première borne de sortie et alimentant la pompe de charge (CP).

7. Dispositif selon l'une des revendications précédentes, réalisé en technologie de type N au sein d'un même circuit intégré.

8. Dispositif selon l'une des revendications précédentes, dans lequel le transistor principal (TP) est un transistor MOS de puissance.

9. Dispositif électronique de protection contre une inversion de polarité d'une tension d'alimentation continue, **caractérisé en ce qu'**il comprend, réalisés au sein d'un même circuit intégré, un transistor principal à canal N (TP) monté sur la ligne de polarité positive attendue de la tension d'alimentation ainsi que des moyens de commande (MCM) du transistor principal comportant un circuit de pompe de charge (CP), associés à un circuit de polarisation dynamique (MCTRL) des régions de substrat de composants actifs connectés au transistor principal, et
les moyens de contrôle sont configurés pour connecter les régions de substrat soit à la source soit au drain du transistor principal en fonction de la valeur des tensions présentes à ces deux électrodes et du type de conductivité de ces régions de substrat.

10. Application du dispositif selon l'une des revendications 1 à 9, à la protection d'une unité électronique d'un véhicule automobile contre des inversions de polarités de l'alimentation continue.

11. Système, comprenant un générateur d'une tension d'alimentation continue (BT), une unité électronique (ECU) destinée à être alimentée par une tension continue et un dispositif (DIS) selon l'une des revendications 1 à 9, couplé entre le générateur et l'unité électronique.

## Patentansprüche

1. Elektronische Vorrichtung, die Eingangseinrichtungen, welche eine erste Eingangsklemme (BEI) besitzen, die dazu bestimmt ist, eine erwartete positive Polarität einer Eingangsversorgungsgleichspannung zu empfangen, Ausgangseinrichtungen, welche eine erste Ausgangsklemme (BS1) besitzen, die dazu bestimmt ist, die positive Polarität einer Ausgangsversorgungsgleichspannung zu liefern, und elektronische Schutzeinrichtungen (MPR) vor einer Verpolung der Eingangsversorgungsspannung enthält, die zwischen den Eingangseinrichtungen und den Ausgangseinrichtungen gekoppelt sind, **dadurch gekennzeichnet, dass** die Schutzeinrichtungen (MPR) integriert ausgeführt sind und einen transistor mit n-Kanal (TP), dessen Source (S) mit der ersten Eingangsklemme (BE1) und dessen Drain (D) mit der ersten Ausgangsklemme (BS1) gekoppelt ist, Steuereinrichtungen (MCM), die konfiguriert sind, um den Haupttransistor (TP) im Fall einer Verpolung zu sperren und im gegenteiligen Fall leitend zu machen, und Kontrolleinrichtungen (MCTRL) enthalten, die konfiguriert sind, um die Polarisation der Substratbereiche (BK) von mit dem Haupttransistor (TP) verbundenen Bauelementen (M42, M2, M35) dynamisch anzupassen, und
die Substratbereiche (BK) der Bauelemente innerhalb von Halbleiterbereichen (RGS) ausgeführt sind, die eine Leitfähigkeit entgegengesetzt zu derjenigen der Substratbereiche haben, wobei die Halbleiterbereiche (RGS) entweder mit der ersten Ausgangsklemme (BS1) oder mit Masse verbunden sind, abhängig von der Art der Leitfähigkeit dieser Halbleiterbereiche, und die Kontrolleinrichtungen (MCTRL) konfiguriert sind, um die Substratbereiche (BK) entweder mit der Source oder mit dem Drain des Haupttransistors zu verbinden, abhängig vom Wert der an diesen zwei Elektroden vorhandenen Spannungen und der Art der Leitfähigkeit dieser Substratbereiche.

2. Vorrichtung nach Anspruch 1, wobei die Substratbereiche (BK) der Bauelemente von der Art mit p-Leitfähigkeit sind, die in Halbleiterbereichen (RGS) von der Art mit n-Leitfähigkeit eingerichtet sind, die mit der ersten Ausgangsklemme verbunden sind, und die Kontrolleinrichtungen (MCTRL) konfiguriert sind, um die p-Substratbereiche mit der Source des Haupttransistors, wenn die Sourcespannung niedriger als die Drainspannung ist, oder mit dem Drain des Haupttransistors zu verbinden, wenn die Sourcespannung höher als die Drainspannung ist.

3. Vorrichtung nach Anspruch 1 oder 2, wobei die Kontrolleinrichtungen (MCTRL) einen Komparator (CMP), dessen zwei Eingänge mit der Source bzw. dem Drain des Haupttransistors (TP) verbunden sind, und einen Multiplexer (MX) aufweisen, der einen mit den Substratbereichen verbundenen Eingang, zwei mit der Source bzw. dem Drain des Haupttransistors verbundene Ausgänge und einen Steuereingang besitzt, der mit dem Ausgang des Komparators verbunden ist.

4. Vorrichtung nach Anspruch 1, 2 oder 3, wobei die Kontrolleinrichtungen (MCTRL) einen ersten Kontrolltransistor (M2), der einen mit seiner Source verbundenen Substratbereich hat, dessen Drain mit der Source des Haupttransistors verbunden ist und dessen Gate mit dem Drain des Haupttransistors verbunden ist, und einen zweiten Kontrolltransistor (M35) aufweisen, der konfiguriert ist, um immer leitend zu sein, dessen Source mit dem Drain des Haupttransistors verbunden ist, dessen Substratbereich mit seinem Drain sowie mit dem Substratbereich des ersten Kontrolltransistors verbunden ist, und dessen Gate mit seinem Drain verbunden ist, wobei der Drain dieses zweiten Kontrolltransistors mit der Source des ersten Kontrolltransistors verbunden ist, wobei die Substratbereiche (BK) der Bauelemente (M42, ZN1, ZN2) mit den Substratbereichen der ersten und zweiten Kontrolltransistoren (M2, M35) verbunden sind, die selbst Teil der Bauelemente sind.

5. Vorrichtung nach einem der vorhergehenden Ansprüche, wobei die Steuereinrichtungen (MCM) eine Ladungspumpenschaltung (CP) enthalten, deren Ausgang mit dem Gate des Haupttransistors verbunden ist.

6. Vorrichtung nach Anspruch 5, wobei die Steuereinrichtungen (MCM) eine Spannungsregelschaltung (RG) enthalten, die mit der ersten Ausgangsklemme verbunden ist und die Ladungspumpe (CP) versorgt.

7. Vorrichtung nach einem der vorhergehenden Ansprüche, die in der n-Technologie innerhalb der gleichen integrierten Schaltung ausgeführt ist.

8. Vorrichtung nach einem der vorhergehenden Ansprüche, wobei der Haupttransistor (TP) ein MOS-Leistungstransistor list

9. Elektronische Schutzvorrichtung vor einer Verpolung einer Versorgungsgleichspannung, **dadurch gekennzeichnet, dass** sie innerhalb der gleichen integrierten Schaltung ausgeführt einen Haupttransistor mit n-Kanal (TP), der auf die Leitung erwarteter positiver Polarität der Versorgungsspannung montiert ist, sowie eine Ladungspumpenschaltung (CP) aufweisende Steuereinrichtungen (MCM) des Haupttransistors enthält, die einer dynamischen Polarisationsschaltung (MCTRL) der Substratbereiche von aktiven Bauelementen zugeordnet sind, die mit dem Haupttransistor verbunden sind, und
die Kontrolleinrichtungen konfiguriert sind, um die Substratbereiche entweder mit der Source oder mit dem Drain des Haupttransistors zu verbinden, abhängig vom Wert der an diesen zwei Elektroden vorhandenen Spannungen und vom Leitfähigkeitstyp dieser Substratbereichem

10. Anwendung der Vorrichtung nach einem der Ansprüche 1 bis 9 zum Schutz einer elektronischen Einheit eines Kraftfahrzeugs vor Verpolungen der Gleichspannungsversorgung.

11. System, das einen Generator einer Versorgungsgleichspannung (BT), eine elektronische Einheit (ECU), die dazu bestimmt ist, mit einer Gleichspannung versorgt zu werden, und eine Vorrichtung (DIS) nach einem der Ansprüche 1 bis 9 zwischen dem Generator und der elektronischen Einheit gekoppelt enthält.

## Claims

1. Electronic device, comprising input means having a first input terminal (BE1) for receiving an expected positive polarity of an input DC power supply voltage, output means having a first output terminal (BS1) for delivering the positive polarity of an output. DC power supply voltage, and electronic means (MPR) for protecting against a polarity reversal of the input power supply voltage, coupled between the input means and the output means, **characterized in that** the protection means (MPR) are produced in an integrated fashion and comprise an N-channel main transistor (TP), the source (S) of which is coupled to the first input terminal (BE1) and the drain (D) of which is coupled to the first output terminal (BS1), command means (MCM) configured to render the main transistor (TP) blocked in the event of a polarity reversal and conducting otherwise, and control means (MCTRL) configured to dynamically adjust the bias of the substrate regions (BK) of components (M42, M2, M35) connected to the main transistor (TP), and
the substrate regions (BK) of said components are realized within semiconductive regions (RGS) having a conductivity opposite to that of the substrate regions, the semiconductive regions (RGS) being connected either to the first output terminal (BS1) or to the ground depending on the type of conductivity of these semiconductive regions, and the control means (MCTRL) are configured to connect the substrate regions (BK) either to the source or to the drain of the main transistor according to the value of the voltages present at these two electrodes and the type of conductivity of these substrate regions.

2. Device according to Claim 1, in which the substrate regions (BK) of said components are of P-conductivity type formed in semiconductive regions (RGS) of N-conductivity type connected to the first output terminal, and the control means (MCTRL) are configured to link said P substrate regions to the source of the main transistor if the source voltage is less than the drain voltage or to the drain of the main transistor if the source voltage is greater than the drain voltage.

3. Device according to Claim 1 or 2, in which the control means (MCTRL) comprise a comparator (CMP) whose two inputs are respectively connected to the source and to the drain of the main transistor (TP), and a multiplexer (MX) having an input connected to said substrate regions, two outputs respectively connected to the source and to the drain of the main transistor and a command input connected to the output of the comparator.

4. Device according to Claim 1, 2 or 3, in which the control means (MCTRL) comprise a first control transistor (M2) having a substrate region connected to its source, the drain of which is connected to the source of the main transistor and the gate of which is connected to the drain of the main transistor, and a second control transistor (M35), configured to be always conducting, having its source connected to the drain of the main transistor, its substrate region connected to its drain and to the substrate region of the first control transistor and its gate connected to its drain, the drain of this second control transistor being connected to the source of the first control transistor, the substrate regions (BK) of said components (M42, ZN1, ZN2) being connected to the substrate regions of the first and second control transistors (M2, M35) which themselves form part of said components.

5. Device according to one of the preceding claims, in which the command means (mum) comprise a charging pump circuit (CP), the output of which is connected to the gate of the main transistor.

6. Device according to Claim 5, in which the command means (MCM) comprise a voltage regulation circuit (RG) connected to the first output terminal and powering the charging pump (CP).

7. Device according to one of the preceding claims, produced in N-type technology within one and the same integrated circuit.

8. Device according to one of the preceding claims, in which the main transistor (TP) is a power MOS transistor.

9. Electronic device for protecting against a polarity reversal of a DC power supply voltage, **characterized in that** it comprises, produced within one and the same integrated circuit, an N-channel main transistor (TP) mounted on the line of expected positive polarity of the power supply voltage and command means (MCM) for the main transistor comprising a charging pump circuit (CP), associated with a dynamic biasing circuit (MCTRL) for the substrate regions of active components connected to the main transistor, and the control means are configured to connect the substrate regions either to the source or to the drain of the main transistor according to the value of the voltages present at these two electrodes and the type of conductivity of these substrate regions.

10. Application of the device according to one of Claims 1 to 9, to the protection of an electronic unit of a motor vesicle against polarity reversals of the DC power supply.

11. System, comprising a generator of a DC power supply voltage (BT), an electronic unit (ECU) designed to be powered by a DC voltage and a device (DIS) according to one of Claims 1 to 9, coupled between the generator and the electronic unit.
